(19) Europäisches Patentamt

European Patent Office

Office européen des brevets

(11) Veröffentlichungsnummer: **0 478 856 A1**

## (12) EUROPÄISCHE PATENTANMELDUNG

(21) Anmeldenummer: **90310931.2**

(22) Anmeldetag: **01.10.90**

(51) Int. Cl.5: **H03K 17/96**

(43) Veröffentlichungstag der Anmeldung:
**08.04.92 Patentblatt 92/15**

(84) Benannte Vertragsstaaten:
**AT BE CH DE DK ES FR GB GR IT LI LU NL SE**

(71) Anmelder: **Siemens Aktiengesellschaft Österreich**
**Siemensstrasse 88 - 92**
**A-1210 Wien(AT)**

(72) Erfinder: **Letheren, Nicholas John**
**12 Bournehall Road**
**Bushey Watford WD2 3EH(GB)**

(74) Vertreter: **Atzwanger, Richard, Dipl.-Ing.**
**Mariahilfer Strasse 1c**
**A-1060 Wien(AT)**

(54) **Verfahren und Vorrichtung zur Kontrolle der Betätigung einer Berührungsplatte.**

(57) Durch die Betätigung einer Berührungsplatte (1) wird die Frequenz eines Oszillators (2) abgesenkt. Ein Zähler (3) registriert die Frequenz und in einem Vergleicher (4) wird der Zählerstand mit festgelegten Werten eines Ein- und Ausschaltregisters (5,6) verglichen. Dadurch wird eine Schalthysterese gebildet. Die Empfindlichkeit der Berührungsplatte wird mit einem Computer (7) durch die Festlegung der Werte in den beiden Registern (5,6) eingestellt.

Fig. 1

EP 0 478 856 A1

Die Erfindung betrifft ein Verfahren zur Kontrolle der Betätigung einer Berührungsplatte durch Bestimmung der Frequenz eines Oszillators.

Ein derartiges Verfahren ist in der US 4,495,485 beschrieben. Beim Berühren der Berührungsplatte sinkt die Frequenz des Oszillators um einen bestimmten Wert ab. Die Empfindlichkeit der Berührungsplatte ist genau zu kontrollieren. Nur dann ist richtiges Ansprechen gewährleistet. Insbesondere bei Mischpulten mit einer großen Zahl von Berührungsplatten kann die Einstellung der Empfindlichkeit sehr aufwendig sein. Sie ist abhängig von der Bauelementetoleranz, Kabellängen und umgebenden Metallteilen.

Der Erfindung liegt die Aufgabe zugrunde, Sicherheit und gute Einstellbarkeit der Ansprechempfindlichkeit zu gewährleisten.

Dies wird gemäß Patentanspruch 1 dadurch erreicht, daß ein Zähler eine festgelegte Zeitspanne mit dem Oszillator verbunden wird, wobei der Zählerstand anschließend proportional zur Oszillatorfrequenz ist und daß der Zählerstand mit mindestens einem voreingestellten Wert verglichen und dadurch eine Berührung registriert wird.

Dadurch kann die Empfindlichkeit so eingestellt werden, daß keine Berührung irrtümlich registriert wird, andererseits aber bereits die leichteste Betätigung der Berührungsplatte richtig erkannt wird.

Eine besonders zuverlässige Arbeitsweise wird dadurch erreicht, daß der Zählerstand mit zwei Werten für berührt und nicht berührt verglichen wird. So kann auch eine individuelle Schalthysterese festgelegt werden. Insbesondere bei Mischpulten ist es vorteilhaft, daß bei Inbetriebnahme vom Computer die Werte in Register geladen werden. So wird auch zum Kalibrieren der Berührungskontrollvorrichtung vom Computer der Zählerstand mit und/oder ohne Berührung der Berührungsplatte gespeichert.

Die Durchführung des Verfahrens erfolgt mit einer Berührungskontrollvorrichtung, bei der die Berührungsplatte mit dem Oszillator und dem Computer verbunden ist, und die dadurch gekennzeichnet ist, daß ein Ausgang des Oszillators mit dem Clock-Eingang eines Zählers und der Zählerausgang mit dem Computer und einem Vergleicher verbunden ist und daß der Ausgang mindestens eines Registers mit dem Vergleicher verbunden ist. Durch eine derartige Vorrichtung wird der Computer durch verlötete Bauelemente entlastet. Es ist vorteilhaft, daß ein Ein- und ein Aus-Register mit unterschiedlichen voreingestellten Werten zur Bildung einer Schalthysterese mit dem Vergleicher verbunden sind.

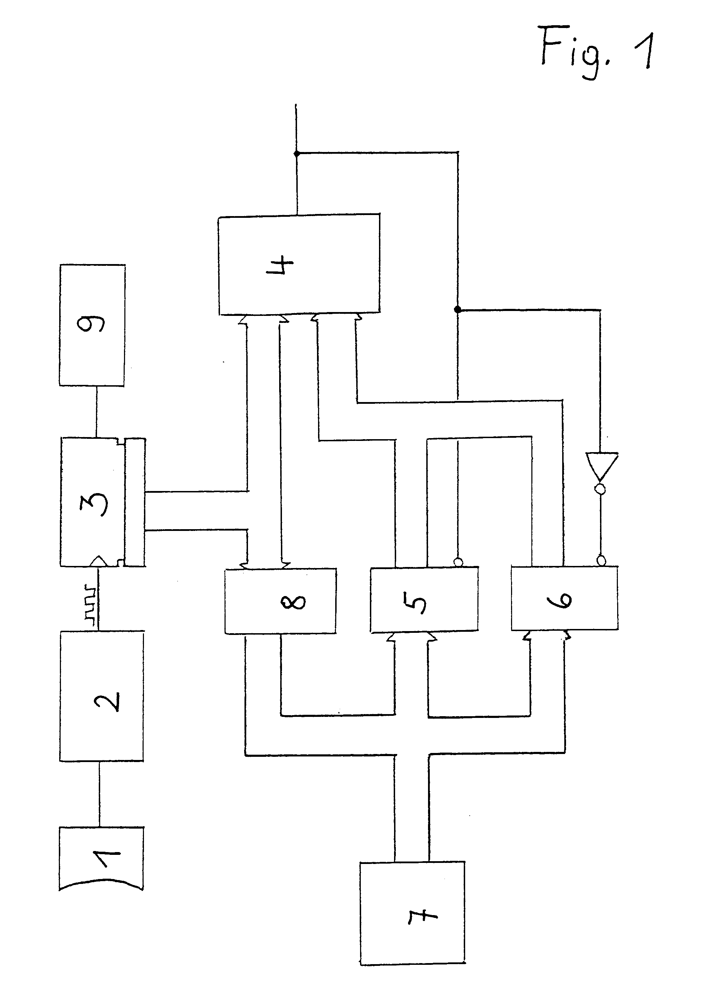

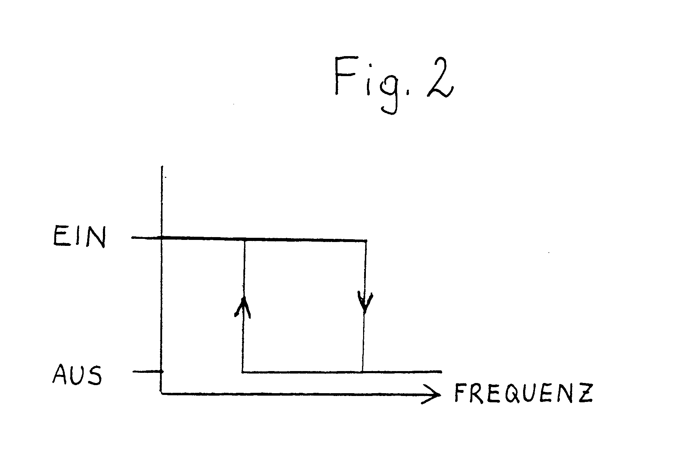

Die Erfindung wird anhand eines Ausführungsbeispieles und Zeichnungen näher erläutert. Es zeigt: Fig. 1 ein Blockschaltbild des Ausführungsbeispieles und Fig. 2 die Schalthysterese Fig. 1 stellt eine Berührungsplatte 1 dar, die mit einem Oszillator 2 verbunden ist. Bei Betätigung der Berührungsplatte 1 wird die Frequenz des Oszillators 2 vermindert. Der Ausgang des Oszillators 2 ist mit dem Clock-Eingang eines Zählers 3 verbunden. Während einer durch einen Zeitgerber 9 festgelegten Zeitspanne wird der Zähler 3 in Gang gesetzt, und der Zählerstand ist anschließend der Frequenz des Oszillators 2 proportional.

Der Zählerstand wird an einen Vergleicher 4 und einen Zwischenspeicher 8 übertragen. Zwei Register, ein Ein-Register 5 und ein Aus-Register 6 sind ebenfalls mit dem Vergleicher 4 verbunden. Der Vergleich des Zählerstandes mit den beiden voreingestellten Werten der Register 5,6 ermöglicht das Feststellen der Berührung. Sie wird als Bit am Vergleicher 4 ausgegeben.

Die in die Register 5,6 eingeschriebenen Werte werden vom Computer 7 berechnet. Zu diesem Zweck ist er auch mit dem Ausgang des Zählers 3 verbunden. Bei einer ersten Inbetriebnahme wird vom Computer 7 der Zählerstand gelesen, wenn die Berührungsplatte 1 nicht betätigt wird. Dieser Wert wird abgespeichert und bleibt auch für später erhalten. Bei einer Wiederinbetriebnahme wird vom Computer 7 der jeweils voreingestellte Wert in das Ein- und Aus-Register 5,6 eingelesen. In gleicher Weise kann beispielsweise auch der Bediener eines Mischpultes mit der erfindungsgemäßen Berührungskontrollvorrichtung seine individuellen Berührungswerte einspeichern. Der Bediener kann die Empfindlichkeit der Berührungsplatte 1 für seine jeweilige Anwendung nachjustieren.

In Fig. 2 ist die Schalthysterese der Berührungsplatte dargestellt. Das Einschalten erfolgt bei einer kleineren Oszillatorfrequenz als das Ausschalten. Die Breite der Hysterese kann vom Bediener individuell festgelegt werden.

## Patentansprüche

1. Verfahren zur Kontrolle der Betätigung einer Berührungsplatte (1) durch die Bestimmung der Frequenz eines Oszillators (2), **dadurch gekennzeichnet,** daß ein Zähler (3) eine festgelegte Zeitspanne mit dem Oszillator (2) verbunden wird, wobei der Zählerstand anschließend proportional zur Oszillatorfrequenz ist und daß der Zählerstand mit mindestens einem voreingestellten Wert verglichen und dadurch eine Berührung registriert wird.

2. Verfahren nach Anspruch 1, **dadurch gekennzeichnet,** daß der Zählerstand mit zwei Werten für berührt und nicht berührt verglichen wird.

3. Verfahren nach Anspruch 1 oder 2, **dadurch**

**gekennzeichnet,** daß bei Inbetriebnahme von einem Computer (7) die Werte in Register (5,6) geladen werden.

4. Verfahren nach einem der vorherigen Ansprüche, **dadurch gekennzeichnet,** daß zum Kalibrieren der Berührungskontrollvorrichtungvom Computer (7) der Zählerstand mit und/oder ohne Berührung der Berührungsplatte (1) gespeichert wird.

5. Berührungskontrollvorrichtung, bei der die Berührungsplatte (1) mit dem Oszillator (2) und dem Computer (7) verbunden ist, **dadurch gekennzeichnet,** daß ein Ausgang des Oszillators (2) mit dem Clock-Eingang eines Zählers (3) und der Zählerausgang mit dem Computer (7) und einem Vergleicher (4) verbunden ist und daß der Ausgang mindestens eines Registers (5,6) mit dem Vergleicher (4) verbunden ist.

6. Vorrichtung nach Anspruch 5, **dadurch gekennzeichnet,** daß ein Ein- und ein Aus-Register (5,6) mit unterschiedlichen voreingestellten Werten zur Bildung einer Schalthysterese mit dem Vergleicher (4) verbunden sind.

Fig. 1

# Fig. 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | GB-A-1 510 034 (COMPUTER IDENTICS CORP.)<br>* Seite 1, Zeilen 14-33; Seite 2, Zeilen 79-102; Seite 3, Zeile 64 - Seite 4, Zeile 43; Figur 6 *<br>– – – | 1,2 | H 03 K 17/96 |
| X | WO-A-8 503 820 (ANTIKIDIS et al.)<br>* Seite 6, Zeile 33 - Seite 8, Zeile 33; Figuren 2,4 *<br>– – – – – | 1,5 | |
| | | | **RECHERCHIERTE SACHGEBIETE (Int. Cl.5)**<br><br>H 03 K<br>H 03 M |

Der vorliegende Recherchenbericht wurde für alle Patentansprüche erstellt

| Recherchenort | Abschlußdatum der Recherche | Prüfer |
|---|---|---|
| Den Haag | 31 Mai 91 | CANTARELLI R.J.H. |